(19) Europäisches Patentamt / European Patent Office / Office européen des brevets

(11) EP 3 628 433 A1

(12) EUROPEAN PATENT APPLICATION

(43) Date of publication:
01.04.2020 Bulletin 2020/14

(51) Int Cl.:
B23K 20/00 (2006.01)     B23K 26/035 (2014.01)
B23K 26/03 (2006.01)     B23K 26/20 (2014.01)
B23K 37/04 (2006.01)     B23K 101/40 (2006.01)

(21) Application number: 19194023.8

(22) Date of filing: 28.08.2019

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 31.08.2018  JP 2018163270

(71) Applicant: JTEKT CORPORATION
Osaka-shi, Osaka 542-8502 (JP)

(72) Inventors:
• IMOTO, Yoshinori
  Osaka-shi,, Osaka 542-8502 (JP)
• SHIIBA, Koichi
  Osaka-shi,, Osaka 542-8502 (JP)
• MATSUHISA, Koichiro
  Osaka-shi,, Osaka 542-8502 (JP)

(74) Representative: Winter, Brandl, Fürniss, Hübner,
Röss, Kaiser, Polte - Partnerschaft mbB
Patent- und Rechtsanwaltskanzlei
Alois-Steinecker-Strasse 22
85354 Freising (DE)

(54) **WELDING APPARATUS AND METHOD OF MANUFACTURING WELDED BODY**

(57)     Provided are a welding apparatus having a reduced size and a method of manufacturing a welded body using the reduced-size welding apparatus. A welding apparatus (21) includes a support base (22) having a placement surface (22a), and a restriction member (23). A substrate (12) with a semiconductor element (13) disposed thereon is placed on the placement surface (22a) such that a surface electrode (14) of the semiconductor element (13) faces upward. A wiring member (15) is placed on the surface electrode (14). The restriction member (23) restricts movement of the surface electrode (14) and the wiring member (15) in the directions away from each other, by holding the substrate (12) with the semiconductor element (13) disposed thereon and the wiring member (15), between the placement surface (22a) and the restriction member (23). The welding apparatus (21) further includes a laser device (25). The laser device (25) locally heats a welding interface between the surface electrode (14) and the wiring member (15) by irradiating a laser beam (L) onto the surface of the wiring member (15) through a hole (23a) in the restriction member (23).

*F I G . 2*

**Description**

BACKGROUND OF THE INVENTION

1. Field of the Invention

The present invention relates to a welding apparatus and a method of manufacturing a welded body.

2. Description of Related Art

There is a known technique that welds two meal members by irradiating a laser beam. For example, Japanese Patent No. 4894528 discloses a welding method that places a wire on a terminal disposed on the surface of a semiconductor element, with a welding material interposed therebetween, and presses a welding portion between the terminal on the surface of the semiconductor element and the wire using a cylindrical pressure nozzle. Then, a laser beam is irradiated onto the surface of the wire through the pressure nozzle so as to locally heat the welding portion between the terminal and the wire and melt the welding material. The melted welding material forms a welding layer, so that the terminal and the wire are welded.

According to the welding method of Japanese Patent No. 4894528, the pressure nozzle presses the welding portion between the terminal on the surface of the semiconductor element and the wire when irradiating a laser beam. However, depending on the material and hardness of the members to be welded, including the terminal and the wire, the welding portion of the members to be welded needs to be pressed with a greater force. Thus, the size of a mechanism for generating a pressing force and hence the size of the welding apparatus may be increased.

SUMMARY OF THE INVENTION

An object of the present invention is to provide a welding apparatus having a reduced size, and a method of manufacturing a welded body without using a large welding apparatus.

According to an aspect of the present invention, there is provided a welding apparatus including:

a restriction device that restricts motion of two stacked metal members in a stacking direction of the two metal members, without pressing the two metal members against each other; and
a heating device that applies heat to cause solid phase diffusion at a welding interface between the two metal members while motion of the two metal members is restricted by the restriction device.

With this configuration, the two metal members are thermally expanded by applying heat to cause solid phase diffusion at the welding interface (welding portion) between the metal members. Since motion of the two metal members in the stacking direction thereof is restricted, pressure generated by thermal expansion of the metal members is applied to the welding interface. As a result, the welding surfaces of the two metal members come into close contact, and solid phase diffusion occurs at the welding interface between the two metal members. Thus, the two metal members are welded.

In this manner, by using the pressure generated by thermal expansion of the metal members, the two metal members can be welded without applying pressure to the welding interface from the outside of the metal members. Therefore, there is no need to have a pressure device for applying pressure to the welding interface from the outside of the metal members. The above welding apparatus includes the restriction device instead of including a pressure device. The restriction device only needs to restrict the motion of the two metal members in the stacking direction thereof. That is, unlike a pressure device, the restriction device does not need to generate a force for pressing the welding interface. Therefore, the size of the restriction device can be reduced compared to a typical pressure device. Accordingly, the size of the welding apparatus can be reduced compared to the size of a welding apparatus including a pressure device.

According to another aspect of the present invention, in the welding apparatus of the above aspect, the restriction device may include a support base having a placement surface on which the two stacked metal members are placed, and a restriction member that holds the two metal members, between the placement surface and the restriction member, to restrict motion of the two metal members in the stacking direction of the two metal members. With this configuration, it is possible to restrict the movement of the two metal members in the stacking direction thereof, by just holding the two metal members on the placement surface, between the placement surface and the restriction member.

According to still another aspect of the present invention, in the welding apparatus of the above aspect, the heating device may be a laser device that heats the welding interface by irradiating a laser beam onto a surface of one of the two metal members that is farther from the placement surface. Further, the restriction member may have a passage through which the laser beam passes. With this configuration, the restriction member does not block the laser beam. Therefore, it is possible to appropriately irradiate a laser beam onto the surface of one of the two metal members that is farther form the placement surface.

According to still another aspect of the present invention, in the welding apparatus of the above aspect, the two metal members may include a surface electrode of a semiconductor element disposed on a substrate or a metal film formed on a surface of the substrate, and a wiring member. With this configuration, the surface electrode of the semiconductor element disposed on the substrate or the metal film formed on the surface of the substrate and the wiring member may be welded. Especially, in the case where the welding apparatus is configured to perform a welding method using the solid phase diffusion described above, heat not high enough to melt the two metal members is applied to the welding interface between the metal members. Therefore, although depending on the heat resistance temperature of the semiconductor element or the substrate, it is possible to weld the surface electrode of the semiconductor element or the metal film formed on the surface of the substrate and the wiring member while reducing the thermal influence on the semiconductor element or the substrate, compared to the case of melting and welding two metal members.

According to still another aspect of the present invention, in the welding apparatus of the above aspect, the two metal members may include a semiconductor element disposed on a substrate, and a heat radiation member. With this configuration, the semiconductor element disposed on the substrate and the heat radiation member may be welded. By performing a welding method using the solid phase diffusion described above, it is possible to weld the semiconductor element and the heat radiation member while reducing the thermal influence on the semiconductor element or the substrate.

According to still another aspect of the present invention, there is provided a method of manufacturing a welded body, the method including: restricting motion of two stacked metal members in a stacking direction of the two metal members without pressing the two metal members against each other, and welding the two metal members by applying heat to cause solid phase diffusion at a welding interface between the two metal members.

According to this manufacturing method, similar to the welding apparatus described above, the two metal members can be welded without applying pressure to the welding interface from the outside of the metal members. Therefore, there is no need to have a pressure device for applying pressure to the welding interface from the outside. Accordingly, it is possible to manufacture a welded body without using a large welding apparatus.

BRIEF DESCRIPTION OF THE DRAWINGS

The foregoing and further features and advantages of the invention will become apparent from the following description of example embodiments with reference to the accompanying drawings, wherein like numerals are used to represent like elements and wherein:

FIG. 1 is a front view of a semiconductor module of a welded body formed by welding two components using a welding apparatus according to an embodiment;
FIG. 2 is a configuration diagram illustrating the schematic configuration of the welding apparatus according to the embodiment;
FIG. 3 is a cross-sectional diagram illustrating a main part of the welding apparatus in which a wiring member is heated from the surface thereof according to the embodiment;
FIG. 4 is a graph illustrating the relationship between the temperature at a welding interface of two metal members and a welding rate of the two metal members according to the embodiment;
FIG. 5 is a graph illustrating the relationship between irradiation conditions (irradiation power and irradiation time) of a laser beam and the temperature at the welding interface of the two metal members according to the embodiment; and
FIG. 6 illustrates a two-dimensional model of the welding interface between the two metal members illustrating the flow of atoms at the welding interface according to the embodiment.

DETAILED DESCRIPTION OF EMBODIMENTS

Hereinafter, an embodiment of a welding apparatus and a method of manufacturing a welded body according to the present invention will be described. The welding apparatus is an apparatus that welds two components each containing metal or having a metal portion by using a laser beam.

First, an example of a welded body formed by welding two components will be described.

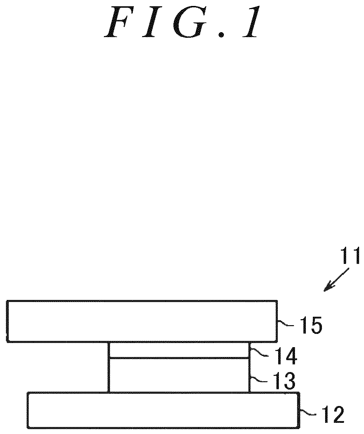

As illustrated in FIG. 1, a semiconductor module 11 corresponding to a welded body is formed by welding a surface electrode 14 of a semiconductor element 13 disposed on a substrate 12 and a wiring member 15. The surface electrode 14 is a metal member made of gold (Au) and formed in the shape of a flat plate or a thin film. The wiring member 15 is a metal member, such as a bus bar and a lead frame, made of copper (Cu) and formed in the shape of a flat plate. The wiring member 15 has a greater thickness than the surface electrode 14.

The surface electrode 14 and the wiring member 15 are welded by solid phase diffusion welding. Solid phase diffusion welding is a method that places two base materials to be welded (the surface electrode 14 and the wiring member 15 in this example), in close contact with each other, applies pressure under conditions of a temperature equal to or lower than the melting points of the base materials while minimizing plastic deformation, and welds the base materials by utilizing diffusion of atoms between the welding surfaces.

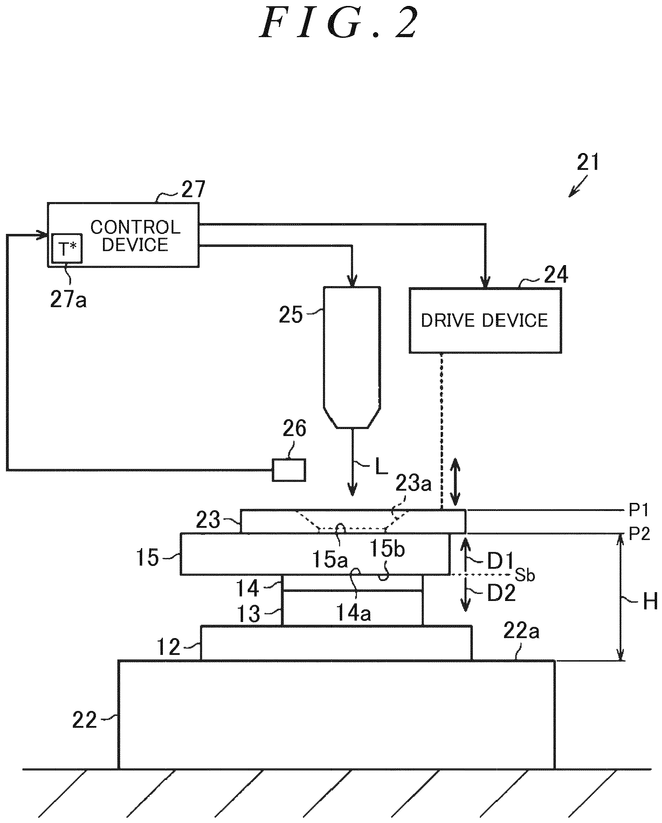

The following describes the welding apparatus. As illustrated in FIG. 2, a welding apparatus 21 includes a support base 22, a restriction member 23, a drive device 24, a laser device 25 serving as a heating device, a temperature sensor 26, and a control device 27.

The support base 22 includes a placement surface 22a on which the substrate 12 and the wiring member 15 are placed. The substrate 12 is placed on the placement surface 22a such that the semiconductor element 13 faces upward (in the direction opposite to the placement surface 22a). The wiring member 15 is placed on the surface electrode 14 of the semiconductor element 13.

The restriction member 23 has the shape of a flat plate. The restriction member 23 is in parallel with the placement surface 22a of the support base 22. The restriction member 23 has a hole 23a serving as a passage. The inner peripheral surface of the hole 23a has a tapered surface having a diameter decreasing toward the placement surface 22a. The restriction member 23 is disposed to be movable in the direction orthogonal to the placement surface 22a. The restriction member 23 moves between an initial position P1 and a restriction position P2. The initial position P1 is a position higher than a height H of the upper surface of the wiring member 15 from the placement surface 22a when the substrate 12 and the wiring member 15 are stacked on the placement surface 22a. The restriction position P2 is a position at the substantially same height as the height H from the placement surface 22a when the substrate 12 and the wiring member 15 are stacked on the placement surface 22a. In FIG. 2, the initial position P1 and the restriction position P2 indicate the position of the lower surface (the side facing the placement surface 22a) of the restriction member 23.

The restriction member 23 and the placement surface 22a of the support base 22 operate in combination with each other to form a restriction device that restricts the motion of two metal members (the wiring member 15 and the surface electrode 14 of the semiconductor element 13 disposed on the substrate 12) in a stacking direction of the metal members (the direction orthogonal to the placement surface 22a) without pressing the metal members against each other.

The drive device 24 moves the restriction member 23 in the direction orthogonal to the placement surface 22a. The drive device 24 includes a drive source such as a motor and a cylinder, and a transmission mechanism that transmits power generated by the drive source to the restriction member 23. In FIG. 2, transmission of power from the drive device 24 to the restriction member 23 is indicated by the dashed lines. The drive device 24 further includes a fixing mechanism that fixes the restriction member 23 to the restriction position P2 when the restriction member 23 is moved from the initial position P1 to the restriction position P2. The fixing mechanism may be, for example, a brake mechanism or a lock mechanism that restricts the motion of the drive source or the transmission mechanism described above.

The laser device 25 irradiates a laser beam L onto the surface of the wiring member 15 through the hole 23a in the restriction member 23. The temperature sensor 26 detects the surface temperature of a laser irradiation region 15a, which is a region to which the laser beam L is irradiated (the region exposed from the hole 23a), on the surface of the wiring member 15, in a non-contact manner.

The control device 27 controls operation of the drive device 24 and the laser device 25. The control device 27 causes the drive device 24 to move the restriction member 23 between the initial position P1 and the restriction position P2. The control device 27 estimates the temperature at a welding interface Sb between the surface electrode 14 and the wiring member 15, based on the surface temperature of the laser irradiation region 15a detected by the temperature sensor 26. The welding interface Sb is the boundary between two welding surfaces 14a and 15b defined by a portion of the surface electrode 14 and a portion of the wiring member 15 welded to each other. The welding surface 14a is the front surface (interface on the wiring member 15 side) of the surface electrode 14. The welding surface 15b is the back surface (interface on the surface electrode 14 side) of the wiring member 15. The control device 27 adjusts the output of the laser device 25 based on the temperature at the welding interface Sb.

The control device 27 includes a storage device 27a. The storage device 27a stores a target temperature $T^*$ (welding temperature). The target temperature $T^*$ is the target value of the temperature at the welding interface Sb that is required to appropriately weld the surface electrode 14 and the wiring member 15. The target temperature $T^*$ is set in a temperature range equal to or higher than a lower limit temperature (for example, about 200°C in the case of copper) at which the metal members (14 and 15) to be welded can be welded by solid phase diffusion and equal to or lower than the melting points of the metal members (14 and 15).

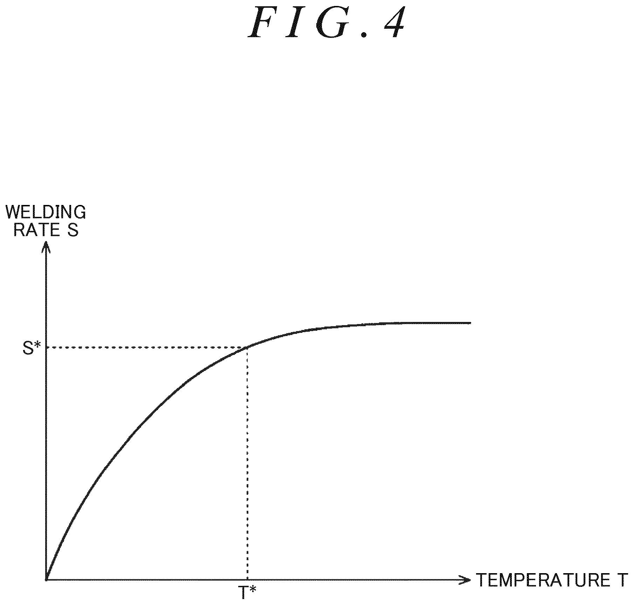

The target temperature $T^*$ is set based on the relationship between the welding rate of the surface electrode 14 and the wiring member 15 and the temperature at the welding interface Sb. The welding rate indicates the ratio of a real welded area to the sum of the real welded area and an apparent welded area. The real welded area represents the area of the portion actually welded at the welding interface Sb. The apparent welded area represents the area of the portion not actually welded at the welding interface Sb. The relationship between the welding rate and the temperature at the welding interface Sb can be obtained from experiments or simulations. An example of the relationship between the temperature at the welding interface Sb and the welding rate is as follows. As illustrated in the graph of FIG. 4, as a temperature T of the welding interface Sb increases, the welding rate S increases gradually. Then, the welding rate S remains constant regardless of the temperature T. A target welding rate S* is first determined, and then the target temperature T* is determined based on the determined welding rate S*.

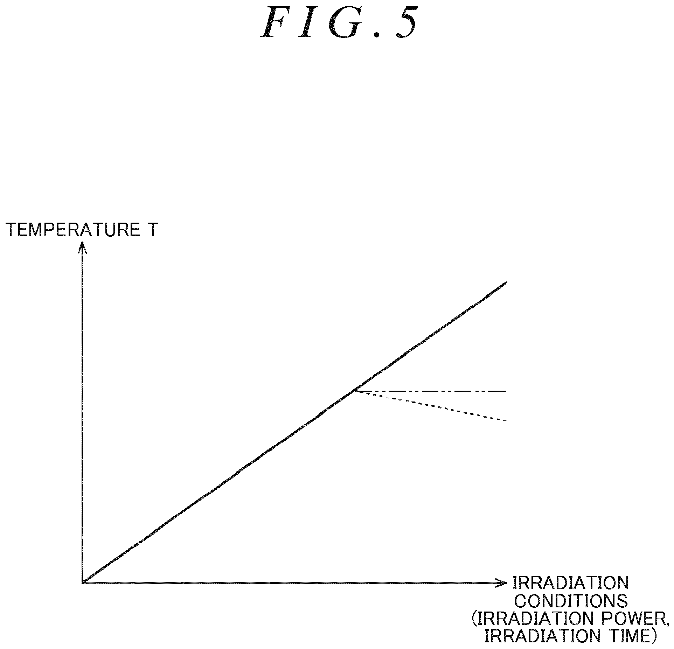

The control device 27 controls the irradiation conditions (irradiation power and irradiation time) of the laser beam L such that the temperature at the welding interface Sb becomes equal to the target temperature T*. An example of the relationship between the temperature T of the welding interface Sb and the irradiation conditions of the laser beam L is as follows. For example, as illustrated in the graph of FIG. 5, as the irradiation power and irradiation time of the laser beam L used as the irradiation conditions of the laser beam L increase, the temperature T at the welding interface Sb increases.

The following describes a method of manufacturing the semiconductor module 11. It is assumed that the substrate 12 with the semiconductor element 13 disposed thereon is prepared in advance. Further, in the welding apparatus 21, the restriction member 23 is held at the initial position P1. The substrate 12 with the semiconductor element 13 thereon facing upward is placed on the placement surface 22a. The wiring member 15 is placed on the surface electrode 14 of the semiconductor element 13. The welding apparatus 21 starts operation from this state.

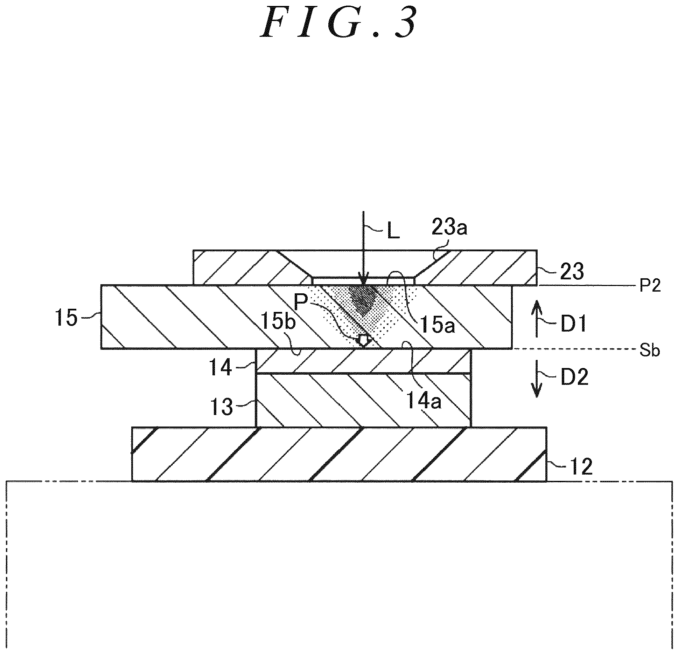

As illustrated in FIG. 3, the control device 27 causes the drive device 24 to move the restriction member 23 from the initial position P1 to the restriction position P2. Thus, the lower surface (the side facing the placement surface 22a) of the restriction member 23 is maintained in contact with the upper surface (the side opposite to the surface electrode 14) of the wiring member 15. In this step, the wiring member 15 is not actively pressed against the surface electrode 14. As the substrate 12 with the semiconductor element 13 disposed thereon and the wiring member 15 are held between the placement surface 22a and the restriction member 23, the movement of the surface electrode 14 and the wiring member 15 in the directions D1 and D2 away from each other (the direction orthogonal to the placement surface 22a) is restricted.

Then, the control device 27 causes the laser device 25 to irradiate the laser beam L onto the laser irradiation region 15a of the wiring member 15. The laser beam L is absorbed by the wiring member 15, so that the wiring member 15 is heated. As indicated by the shaded region in FIG. 3, heat generated by irradiation of the laser beam L is transferred from the front surface toward the back surface of the wiring member 15. The control device 27 causes the laser device 25 to irradiate the laser beam L onto the laser irradiation region 15a until the temperature T at the boundary between the welding surface 15b defined by the back surface of the wiring member 15 and the welding surface 14a defined by the front surface of the surface electrode 14, that is, the welding interface Sb reaches the target temperature T*. Note that in the shaded region in FIG. 3, the darker the shade (dots), the higher the temperature; and the lighter the shade, the lower the temperature.

The wiring member 15 thermally expands with an increase in temperature due to application of heat. Since the deformation of the wiring member 15 toward the side opposite to the placement surface 22a (upward in FIG. 3) is restricted by the restriction member 23, the wiring member 15 expands in the direction toward the surface electrode 14 (downward direction in FIG. 3) in which the wiring member 15 is most easily deformed. Therefore, downward pressure P generated by thermal expansion of the wiring member 15 in the thickness direction is applied to the welding surface 14a defined by the front surface of the surface electrode 14. As the pressure is applied, the peaks of the fine irregularities on the welding surface 15b of the wiring member 15 and the welding surface 14a of the surface electrode 14 contact and crush each other. Thus, the welding surface 15b and the welding surface 14a come into closer contact with each other.

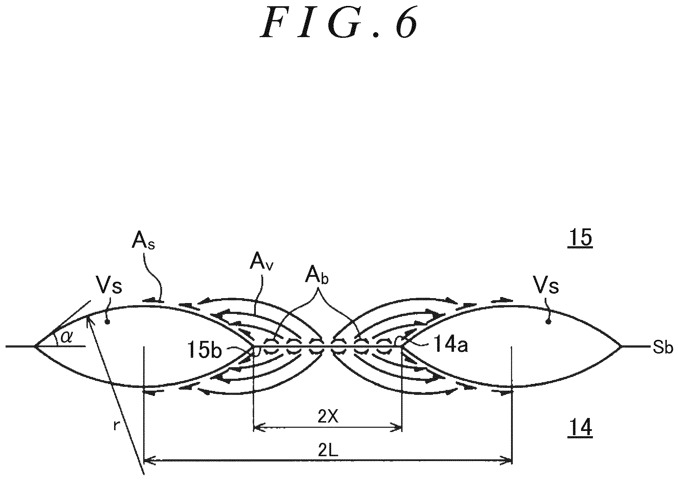

As illustrated in the two-dimensional model of the welding interface of FIG. 6, immediately after starting welding, voids (pores) Vs are formed at the welding interface Sb defining the boundary between the welding surface 15b and the welding surface 14a. As the welding surface 15b and the welding surface 14a come into closer contact with each other, diffusion of atoms (surface diffusion $A_s$, interface diffusion $A_b$, and volume diffusion $A_v$) eventually occurs at the welding interface Sb between the surface electrode 14 and the wiring member 15. The surface diffusion $A_s$ is diffusion through the surfaces of the voids Vs. The interface diffusion $A_b$ is diffusion through the welding interface Sb. The volume diffusion $A_v$ is diffusion through the crystals (crystal lattice). The voids Vs at the welding interface Sb shrink or disappear through the diffusion (solid phase diffusion) of atoms and creep deformation in the vicinity of the welding interface Sb, so that the welding between the welding surface 14a of the surface electrode 14 and the welding surface 15b of the wiring member 15 progresses. That is, as the voids Vs shrink and disappear, the apparent welded area representing the area of the portion not actually welded at the welding interface Sb decreases, and the real welding area representing the area of the portion actually welded at the welding interface Sb increases.

The speed of progress of solid phase diffusion welding (shrinking speed of void Vs) is represented by the following Expression (1).

$$\left(\frac{dS}{dt}\right)_{diff} = \frac{3sin\alpha \cdot \omega}{kT(2\alpha - sin2\alpha)rX^2}\left(\frac{P}{S} + \frac{\gamma_s}{r}\right)\left(\delta_b D_b + \frac{2L}{\pi}D_v\right) \quad (1)$$

In the two-dimensional model of the welding interface Sb of FIG. 6, $\alpha$ is an angle between the welding interface Sb (the boundary line between the welding surface 14a and the welding surface 15b) and the normal line at an end (left end in FIG. 6) of the void Vs. The welding rate S in the two-dimensional model of the welding interface Sb of FIG. 6 can be represented by the following Expression (2).

$$S = X/L \quad (2)$$

Here, assuming that the voids Vs are periodically formed at a constant pitch (intervals), X is half of a length 2X of the welding portion between two adjacent voids Vs and Vs, and L is half of the length of a pitch 2L representing the center distance between two adjacent voids Vs and Vs.

The speed of progress of creep deformation in the vicinity of the welding interface Sb (contact speed) is represented by the following Expressions (3) and (4). Expression (3) represents the speed of progress of creep deformation when the welding rate S is less than 50%, and Expression (4) represents the speed of creep deformation when the welding rate S is equal to or greater than 50%.

$$\left(\frac{dS}{dt}\right)_{S<50\%} = \frac{A \cdot S \cdot \left(\frac{\sqrt{3}}{2}\right)^{n+1}}{\{1 - S^{2/n}\}^n}\left\{\frac{2P}{nG}\left(\frac{1-S}{S}\right)\right\}^n \quad (3)$$

$$\left(\frac{dS}{dt}\right)_{S\geq50\%} = \frac{A(1-S)\left(\frac{\sqrt{3}}{2}\right)^{n+1}\left(\frac{2P}{nG}\right)^n}{\{1 - (1-S)^{2/n}\}^n} \quad (4)$$

Here, G is an effective modulus of rigidity, and n is a stress index. In the above Expressions (3) and (4), A is a value represented by the following Expression (5).

$$A = A_0 exp(-Q_c/RT) \quad (5)$$

Here, Ao is a creep constant; $Q_c$ is an activation energy of interface creep deformation; and R is a gas constant.

When the temperature at the welding interface Sb reaches the target temperature T*, then the control device 27 continues to heat for a predetermined heating time. Accordingly, the voids Vs continue to shrink and disappear due to creep deformation in the vicinity of the welding interface Sb and diffusion of atoms. Thus, the welding rate S increases according to the above Expressions (1), (3), and (4), and eventually reaches the target welding rate S* (welding strength). In the case where the target welding rate S* is, for example, 1 (the maximum value), the welding surface 14a of the surface electrode 14 and the welding surface 15b of the wiring member 15 are completely welded across the entire target welding area on the welding surfaces 14a and 15b. At the mutually welded portions of the welding surfaces 14a and 15b corresponding to the welding area, the welding interface Sb present immediately after starting welding has disappeared.

According to the present embodiment, the following effects can be obtained.

(1) Two stacked metal members (14 and 15) are welded using pressure that is generated by thermal expansion of the metal members caused by applying heat to the welding interface Sb (welding portion) between the two metal members while restricting the motion of the two metal members in the directions (D1 and D2) away from each other. Since the two metal members can be welded without actively applying pressure to the welding interface Sb from the outside of the metal members, there is no need to have a pressure device for applying pressure to the welding interface Sb from the outside of the metal members. The welding apparatus 21 includes the drive device 24 that moves the restriction member 23 instead of including the pressure device. The drive device 24 only needs to generate a force sufficient to move the restriction member 23. That is, unlike the pressure device, the drive device 24 does not need to generate a large force for applying pressure to the welding interface Sb. Therefore, the size of the drive device 24 can be reduced compared to the pressure device. Accordingly, the size of the welding apparatus 21 can be reduced compared to the size of a welding apparatus including the pressure device.

(2) It is possible to restrict the motion of the two metal members in the directions D1 and D2 away from each other, by just maintaining the restriction member 23 in contact with the surface of the upper metal member (15) of the two metal members (14 and 15) stacked on the placement surface 22a. Moreover, the configuration of the welding apparatus 21 is not complicated.

(3) The restriction member 23 has the hole 23a corresponding to the laser irradiation region 15a on the surface of the wiring member 15. Therefore, it is possible to restrict the movement of the surface electrode 14 and the wiring member 15 in the directions away from each other, D1 and D2, without preventing irradiation of the laser beam L onto the wiring member 15.

(4) The control device is provided that controls the heating device to heat the welding interface based on the optimum heating conditions (temperature range) obtained from the relationship between the temperature at the welding interface and the shrinkage status of voids that is calculated in advance. Thus, the welding interface is heated to an appropriate temperature, so that the metal members are appropriately thermally expanded. Then, appropriate pressure generated by appropriate thermal expansion is applied to the welding interface, thereby causing appropriate solid phase diffusion.

The present embodiment may be modified as described below. The target temperature T* may be calculated from the relationship between the temperature T at the welding interface Sb and the shrinkage status of the voids Vs (progress of welding) represented by the above Expression (1).

The relationship between the temperature T at the welding interface Sb and the irradiation conditions of the laser beam L (irradiation power and irradiation time) of the laser beam L is not limited to the characteristic illustrated in FIG. 5. For example, the following two characteristics are possible. According to the first characteristic, as indicated by the long dashed double-short dashed lines in FIG. 5, as the irradiation power and irradiation time increase, the temperature T at the welding interface Sb increases, and eventually remains constant regardless of the irradiation power and irradiation time. According to the second characteristic, as indicated by the dashed lines in FIG. 5, as the irradiation power and irradiation time increase, the temperature T at the welding interface Sb increases. Then, conversely, as the irradiation power and irradiation time increase, the temperature T at the welding interface Sb decreases. The relationship between the temperature T at the welding interface Sb and the irradiation power of the laser beam L and the relationship between the temperature T at the welding interface Sb and the irradiation time of the laser beam L may have characteristics different from each other.

The welding apparatus 21 is capable of not only welding the surface electrode 14 and the wiring member 15 to each other, but also welding metal members having various shapes to each other, such as welding a metal member (wire) and a pad (electrode) on the substrate 12 to each other, or welding a metal film such as plating formed on the surface of the substrate 12 and the wiring member 15 to each other. The welding apparatus 21 can also weld the semiconductor element 13 as a metal member disposed on the substrate 12 and the heat radiation member (heatsink) as a metal member. By performing the welding method using solid phase diffusion, it is possible to weld the semiconductor element and the heat radiation member while reducing the thermal influence on the semiconductor element 13 or the substrate 12.

The metal materials of the objects to be welded are not limited to gold and copper, and may be selected from other various metal materials such as aluminum (Al), silver (Ag), and aluminum-silicon alloy (Al-Si system). The welding apparatus 21 can weld metals of the same type to each other and metals of different types to each other.

A sensor that detects the amount of infrared rays from the laser irradiation region 15a of the wiring member 15 or the reflection amount of the laser beam L may be used in place of the temperature sensor 26. The amount of infrared rays and the reflection amount of the laser beam L (absorption amount of the laser beam L) are correlated with the surface temperature of the wiring member 15. Therefore, the temperature of the welding interface Sb can be estimated based on the amount of infrared rays from the laser irradiation region 15a and the reflection amount of the laser beam L. Further, a contact temperature sensor may be used in place of the non-contact temperature sensor 26. The contact temperature sensor may be arranged as follows. That is, the contact temperature sensor may be disposed on the contact surface of the restriction member 23 with respect to the wiring member 15, or may be disposed such that the contact temperature sensor contacts the wiring member 15 when the restriction member 23 approaches the wiring member 15. Alternatively, the contact temperature sensor may be disposed on the substrate 12.

A pressure sensor may be used in place of the temperature sensor 26. The pressure sensor detects pressure generated by thermal expansion of the wiring member 15. The control device 27 stores in advance the relationship between the pressure (pressing force) generated by thermal expansion of the wiring member 15 and the welding rate S, and determines that the temperature at the welding interface Sb has reached the temperature corresponding to the target welding rate S* when the pressure detected by the pressure sensor has reached the value corresponding to the target welding rate S*.

Depending on the configuration or the type of the drive source and the transmission mechanism of the drive device 24, in the case where the restriction member 23 can be fixed to the restriction position P2 by the frictional force at the part where contact motion is performed in the drive source and the transmission mechanism when the drive device 24 is stopped, the drive device 24 may be configured without including a fixing mechanism that fixes the restriction member 23 to the restriction position P2.

The hole 23a in the restriction member 23 may have any suitable shape such as circle and rectangle. That is, the hole 23a may have any shape that allows passage of the laser beam L. Alternatively, the restriction member 23 may have a cutout (a portion that is removed) in place of the hole 23a. The cutout extends from the edge of the restriction member 23 to the portion corresponding to the irradiation path of the laser beam L (for example, the center of the restriction member 23).

The restriction member 23 may be configured as follows. For example, the restriction member 23 includes a plurality of (for example, two) members spaced apart from each other. If this configuration is employed, the clearance between the two members serves as a passage through which the laser beam L passes. Thus, the laser beam L is irradiated onto the surface (laser irradiation region 15a) of the surface electrode 14 through the clearance between the two members.

A heating device having the following configuration for applying heat to the welding interface Sb may be used in place of the laser device 25. That is, while elements corresponding to the placement surface 22a and the restriction member 23 of the present embodiment restrict the movement of the two stacked metal members in the directions away from each other (stacking direction), two electrodes are brought into contact with the target welding locations of the two metal members from the opposite sides so as to establish electric conduction, and an electric current is applied between the two electrodes. Then, the welding portion (welding interface) between the two metal members is heated by Joule heat that is generated by the contact resistance at the welding portion (welding interface) between the two metal members. In this step, since deformation of the two metal members in the directions away from each other is restricted, the pressure generated by thermal expansion of the two metal members is applied to the welding portion between the two metal members. Accordingly, there is no need to apply a pressing force from the outside to the welding portion between the two metal members through two electrodes.

## Claims

1. A welding apparatus comprising:

   a restriction device that restricts motion of two stacked metal members in a stacking direction of the two metal members, without pressing the two metal members against each other; and
   a heating device that applies heat to cause solid phase diffusion at a welding interface between the two metal members while motion of the two metal members is restricted by the restriction device.

2. The welding apparatus according to claim 1, wherein the restriction device includes
   a support base having a placement surface on which the two stacked metal members are placed, and
   a restriction member that holds the two metal members, between the placement surface and the restriction member, to restrict motion of the two metal members in the stacking direction of the two metal members.

3. The welding apparatus according to claim 2, wherein:

   the heating device is a laser device that heats the welding interface by irradiating a laser beam onto a surface of one of the two metal members that is farther from the placement surface; and
   the restriction member has a passage through which the laser beam passes.

4. The welding apparatus according to any one of claims 1 to 3, wherein the two metal members include a surface electrode of a semiconductor element disposed on a substrate or a metal film formed on a surface of the substrate, and a wiring member.

5. The welding apparatus according to any one of claims 1 to 3, wherein the two metal members include a semiconductor element disposed on a substrate, and a heat radiation member.

6. A method of manufacturing a welded body, the method comprising:
restricting motion of two stacked metal members in a stacking direction of the two metal members without pressing the two metal members against each other, and welding the two metal members by applying heat to cause solid phase diffusion at a welding interface between the two metal members.

# F I G . 1

11

15

14

13

12

# FIG.2

# FIG. 3

# FIG.4

# F I G . 5

TEMPERATURE T

IRRADIATION
CONDITIONS
(IRRADIATION POWER,
IRRADIATION TIME)

# FIG.6

Europäisches
Patentamt

European
Patent Office

Office européen
des brevets

## EUROPEAN SEARCH REPORT

Application Number

EP 19 19 4023

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/110435 A1 (NAGAHAMA TAKAYA [JP] ET AL) 20 April 2017 (2017-04-20) * abstract * * figures 16,17 * * paragraph [0160] - paragraph [0164] * ----- | 1-6 | INV. B23K20/00 B23K26/035 B23K26/03 B23K26/20 B23K37/04 |
| X | US 2003/127434 A1 (RUBEN DAVID A [US]) 10 July 2003 (2003-07-10) * figure * * ----- | 1-5 | ADD. B23K101/40 |
| X | EP 2 036 653 A1 (TECNOLASER S R L [IT]) 18 March 2009 (2009-03-18) * abstract * * figure 3 * * paragraph [0026] - paragraph [0034] * * claims 1-3 * ----- | 1-5 | |
| X | US 4 973 817 A (KANNO HIROYUKI [JP] ET AL) 27 November 1990 (1990-11-27) * figure 5 * ----- | 1-5 | |
| X | KR 2013 0069202 A (SUNG WOO HITECH CO LTD [KR]) 26 June 2013 (2013-06-26) * figure * * ----- | 1-5 | |

TECHNICAL FIELDS
SEARCHED       (IPC)

B23K

The present search report has been drawn up for all claims

| Place of search | Date of completion of the search | Examiner |
|---|---|---|
| Munich | 7 February 2020 | Perret, William |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

........................................................................
& : member of the same patent family, corresponding document

EPO FORM 1503 03.82 (P04C01)

**EP 3 628 433 A1**

## ANNEX TO THE EUROPEAN SEARCH REPORT
## ON EUROPEAN PATENT APPLICATION NO.

EP 19 19 4023

This annex lists the patent family members relating to the patent documents cited in the above-mentioned European search report.
The members are as contained in the European Patent Office EDP file on
The European Patent Office is in no way liable for these particulars which are merely given for the purpose of information.

07-02-2020

| Patent document cited in search report | | Publication date | Patent family member(s) | | Publication date |
|---|---|---|---|---|---|
| US 2017110435 | A1 | 20-04-2017 | DE 102016119215 A1<br>US 2017110435 A1 | | 20-04-2017<br>20-04-2017 |
| US 2003127434 | A1 | 10-07-2003 | DE 60017176 T2<br>EP 1226000 A1<br>US 6501043 B1<br>US 2003127434 A1<br>US 2004256367 A1<br>WO 0130530 A1 | | 25-05-2005<br>31-07-2002<br>31-12-2002<br>10-07-2003<br>23-12-2004<br>03-05-2001 |
| EP 2036653 | A1 | 18-03-2009 | NONE | | |
| US 4973817 | A | 27-11-1990 | JP H0228071 A<br>JP H0829726 B2<br>US 4973817 A | | 30-01-1990<br>27-03-1996<br>27-11-1990 |
| KR 20130069202 | A | 26-06-2013 | NONE | | |

For more details about this annex : see Official Journal of the European Patent Office, No. 12/82

**EP 3 628 433 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4894528 B